# EUROPEAN PATENT APPLICATION

(11) **EP 3 893 012 A1**
(43) Date of publication of application: **13.10.2021**
(21) Application number: 20168451.1
(22) Date of filing: 07.04.2020
(51) Int. Cl.: G01R 33/42, H05K 9/00, H01B 12/10

(54) **A COMPOUND MATERIAL FOR A MAGNETIC SHIELD OF A MAGNETIC RESONANCE IMAGING SYSTEM**

(71) Applicant: Koninklijke Philips N.V., 5656 AG Eindhoven (NL)
(72) Inventor: FORTHMANN, Peter, 5656 AE Eindhoven (NL); MULDER, Gerardus Bernardus Jozef, 5656 AE Eindhoven (NL)
(74) Representative: Philips Intellectual Property & Standards

(57) **Abstract**

For a magnetic shield a solution for a designable time-constant shall be implemented. This is achieved by a compound material for a magnetic shield of a magnetic resonance (MR) imaging system the compound material comprising fragmented superconducting material (2), wherein the fragmented superconducting material (2) comprises fibers or wires (4), wherein the fibers or wires (4) of the fragmented superconducting material (2) are dispersed in a normal conducting metal or alloy (3). The present invention also refers to a magnetic shield for a magnetic resonance (MR) imaging system, wherein at least one surface of the magnetic shield (1) is covered with such a compound material. The present invention also refers to a magnetic resonance (MR) imaging system comprising such a magnetic shield and to a method for producing a compound material for a magnetic shield of a magnetic resonance (MR) imaging system.

## Description

### FIELD OF THE INVENTION

The invention relates to the field of magnetic resonance (MR) imaging systems, and in particular to a compound material for a magnetic shield of a magnetic resonance (MR) imaging system, to a magnetic shield for a magnetic resonance (MR) imaging system, to a magnetic resonance (MR) imaging system and to a method for producing a compound material for a magnetic shield of a magnetic resonance (MR) imaging system.

### BACKGROUND OF THE INVENTION

Magnetic resonance (MR) imaging systems are often used for the examination of patients, further referred to in general as subject of interest. In order to examine a body of a subject of interest, typically a patient, using magnetic resonance imaging (MRI) systems, different magnetic fields, which are tuned to one another as precisely as possible with respect to their temporal and spatial characteristics, are radiated onto the subject of interest. Hence, the nuclear spins of body tissue of the subject of interest to be examined are aligned by a static main magnetic field Bo. A powerful main magnet generates a powerful static main magnetic field Bo, which typically is provided with a magnetic field strength of 1.5 Tesla or 3 Tesla, in some embodiments with a magnetic field strength of more than 3 Tesla. The nuclear spins of atomic nuclei of the subject of interest are excited by magnetic radio-frequency excitation pulses B1 (x, y, z, t), which are radiated into the nuclei via a radio-frequency antenna and/or a local coil arrangement. Still further, high frequency excitation pulses are generated and guided to the radio-frequency antenna.

The MRI system further includes gradient coils, with which magnetic gradient fields BG(x, y, z, t) are radiated during a measurement for selective slice excitation and for spatial encoding of the measuring signal. Signals emitted by the excited nuclear spins of the atomic nuclei in the subject of interest to be examined are received by at least one RF receive coil, amplified, further processed and digitized. The recorded measured data is digitized and stored as complex numerical values in a k-space matrix. An associated MR image may be reconstructed from the k-space matrix containing the complex numerical values by, for example, a multidimensional Fourier transformation.

In MR imaging, relaxation signals are exposed to gradient magnetic fields to localize the resultant resonance. The relaxation signals are received and reconstructed into a single or multi-dimensional image. Furthermore, in MR spectroscopy systems, information about the composition of the tissue, which is carried in the frequency component of the resonance signals, is further evaluated to obtain additional information.

The main magnet comprises a set of main coils, typically superconductive magnet coils, which have to be kept at very low temperature to enable superconduction. Hence, the main coils are mounted within a radiation shield as cryostat. In order to keep the main coils at superconducting temperature, the main coils are in contact with liquid cryogen. The cryogen is typically provided as liquid having a low boiling temperature, e.g. a boiling temperature of about 4.2 K in case of helium. Cooling of the radiation shield is performed by a cryopump connected through heat conductors at one or several points on the its surface. In addition to the main coils, the main magnet typically comprises active shield coils, which are located within the radiation shield and co-axially outside the main coils, and which are electrically connected in a direction opposite to the main coils.

Some applications require magnetic fields to be shielded. Superconducting materials are almost perfect shields. However, there is a drawback in that if currents can flow indefinitely, they may accumulate and eventually cause uncontrolled behavior like quenching. Therefore, a certain finite conductivity is required to make the currents die down with some finite time constant. In terms of conductivity of available materials, though, there is a gap between a superconductor and a normal conducting metal or alloy.

### SUMMARY OF THE INVENTION

It is an object of the invention to provide a compound material for a magnetic shield of a magnetic resonance (MR) imaging system which overcome at least some of the above disadvantages. In particular, it is an object of the present invention to provide a compound material for a magnetic shield of a magnetic resonance (MR) imaging system with arbitrary eddy current time constant, wherein depending on the application, the conductivities and/or time constants fall right in that gap, i.e. somewhere between that of a superconductor and a normal conductor.

According to the invention, this object is addressed by the subject matter of the independent claims. Preferred embodiments of the invention are described in the sub claims. Therefore, according to the invention, this object is achieved by a compound material for a magnetic shield of a magnetic resonance (MR) imaging system the compound material comprising fragmented superconducting material, wherein the fragmented superconducting material comprises fibers or wires, wherein the fibers or wires of the fragmented superconducting material are dispersed in a normal conducting metal or alloy.

The term fragmented superconducting material can thus be understood as a material that comprises fibers or wires. The compound material can also include filaments of the superconducting material, for example. The basic idea of the present invention is creating a compound material for a magnetic shield of a magnetic resonance (MR) imaging system, the compound material consisting of fragmented superconductors in a normal conducting metal or alloy. Due to the compound material a magnetic shield with a designable time-constant is realized. Since there are no contiguous single-material current paths, electrical currents in such a compound have to flow through the resistive material as well as through the superconductive material. With this ingenious material, time constants in the range of about 1 to about 1000 seconds can be achieved for a magnetic shield of a magnetic resonance (MR) imaging system. The alloy can e.g. be an alloy with a low-melting point so that the superconducting material can be very easily incorporated into the alloy forming the inventive compound material. The designable time constant of the compound material depends on the degree of the alignment and integration of the superconducting material induced during the compound material manufacturing process into the normal conducting metal or alloy.

According to an advantageous embodiment of the invention the fragmented superconducting material comprises fibers or wires in a certain length, wherein the fibers or wires are disposed in a high-density in the normal conducting metal or alloy, wherein the volumetric ratio of the fragmented superconducting material in the compound material is between 60% to 95%. The integral conductivity of the compound material will be a function of the volume fraction and the dimensions of the fragmented superconducting material incorporated into the metal or alloy. Therefore for certain applications fibers or wires disposed in a high-density in the normal conducting metal or alloy is advantageous.

Preferably the length of the short fibers or wires of the fragmented superconducting material is from about 0.1 mm to about 8 cm.

According to another advantageous embodiment of the invention the fragmented superconducting material comprises fibers or wires in a certain length, wherein the fibers or wires are disposed in a low-density in the normal conducting metal or alloy, wherein the volumetric ratio of the fragmented superconducting material in the compound material is between 5% to 40%.

For other applications, longer fibres or wires can also be advantageous, therefore preferably the length of the long fibers or wires of the fragmented superconducting material is from about 8 cm and longer.

According to an advantageous embodiment of the invention the fibers or wires of the fragmented superconducting material are essentially aligned in one direction. The orientation of the fibers in a preferred direction has the advantage, that the compound material can be engineered with anisotropic properties.

Preferably the fibers or wires of the fragmented superconducting material are essentially aligned radially over a surface of a main magnet of the magnetic resonance (MR) imaging system.

The present invention also provides a magnetic shield for a magnetic resonance (MR) imaging system, wherein at least one surface of the magnetic shield is covered with the compound material as described above.

The present invention also provides a magnetic resonance (MR) imaging system comprising a magnetic shield according as described above.

According to an advantageous embodiment of the invention the magnetic shield is disposed around a coldhead of a magnet of the MR imaging system.

The present invention also provides a method for producing a compound material for a magnetic shield of a magnetic resonance (MR) imaging system, comprising the steps of
- providing a normal conducting metal or alloy,
- providing fibers or wires of a fragmented superconducting material,
- forming an emulsion of the normal conducting metal alloy with the fibers or wires of the fragmented superconducting material. Various technologies can be used to produce the fragmented superconducting material. The fragmented superconducting material can be produced, for example, by cutting longer superconducting fibers or wires to obtain the desired length of the fibers or wires.

According to a preferred embodiment of the invention the step of forming an emulsion of the normal conducting metal or alloy with the fibers and wires of the fragmented superconducting material, comprises the step of commonly aligning the fibers or wires essentially in one direction. By using a production process that orients the fibers or wires in a preferred direction the compound material can have engineered anisotropic properties.

### BRIEF DESCRIPTION OF THE DRAWINGS

These and other aspects of the invention will be apparent from and elucidated with reference to the embodiments described hereinafter. Such an embodiment does not necessarily represent the full scope of the invention, however, and reference is made therefore to the claims and herein for interpreting the scope of the invention.

In the drawings:
Fig. 1 schematically depicts a surface covered with a compound material according to a first embodiment of the invention,
Fig. 2 schematically depicts a surface covered with a compound material according to a second embodiment of the invention,
Fig. 3 schematically depicts a surface covered with a compound material according to a third embodiment of the invention,

### DETAILED DESCRIPTION OF EMBODIMENTS

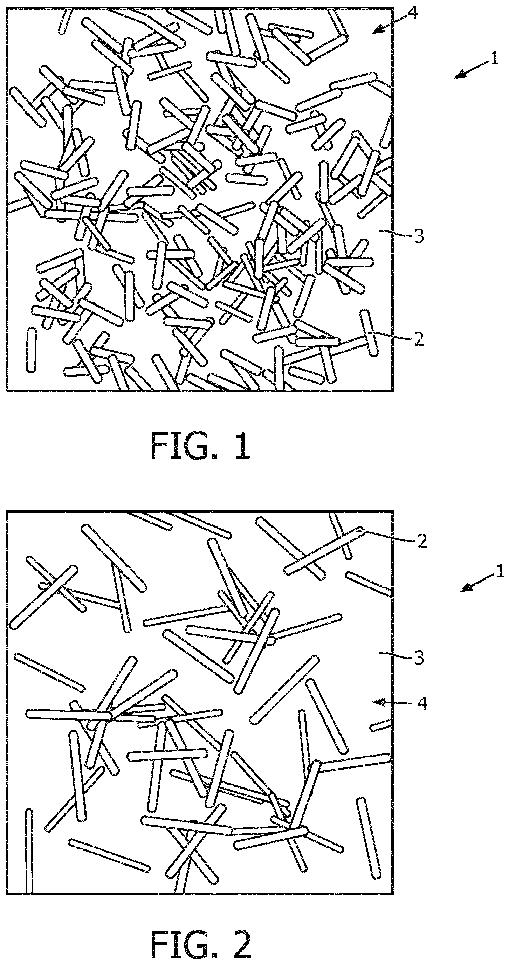

Fig. 1 schematically depicts a surface 1 covered with a compound material according to a first embodiment of the invention. For example, the surface 1 shown in Fig. 1 can be the surface of a magnetic shield for a magnetic resonance (MR) imaging system. The surface 1 of the magnetic shield is covered with a compound material, wherein the compound material comprises fragmented superconducting material 2 dispersed in a normal conducting metal or alloy 3. The superconductor 2 should have a higher melting point than the normal conducting metal or alloy 3. The material can be aluminum or solder, for example. The approach relies on superconductors 2, but it is not geared to a certain type of superconductor. The possible operating temperatures of such a compound material can e.g. range between 0 K and 80 K, but high temperature superconductors, with even higher transition temperatures, can also be provided. For example, the following materials can be considered as materials for the superconductor 2 Nb₃Sn, NbTi, MgB₂, ReBCO. In Fig. 1 it can be seen that the fragmented superconducting material 2 comprises fibers or wires 4 in a certain length disposed in a high-density in the normal conducting metal or alloy 3. A high-density means in this context that the volumetric ratio of the superconductor in the compound is e.g. between 60 % to 95 %, wherein 0 % means no superconductor 2 is present in the compound and 100 % means only the superconductor 2 is present. In an embodiment of the invention the length of the fibers or wires 4 is from about 0.1 mm to about a few centimeters.

Fig. 2 schematically depicts a surface 1 covered with a compound material according to a second embodiment of the invention. Also, in the embodiment of the invention shown in Fig. 2 the surface 1 can be the surface of a magnetic shield for a magnetic resonance (MR) imaging system. The fragmented superconducting material 2 shown in Fig. 2 comprises fibers or wires 4 with a certain length disposed in a low-density in the normal conducting metal or alloy 3. A low-density means in this context that the volumetric ratio of the superconductor 2 in the compound is e.g. between 5 % to 40 %, wherein 0 % means no superconductor 2 is present in the compound and 100 % means only the superconductor 2 is present. In an embodiment of the invention the length of the fibers or wires 4 is more than a few centimeters.

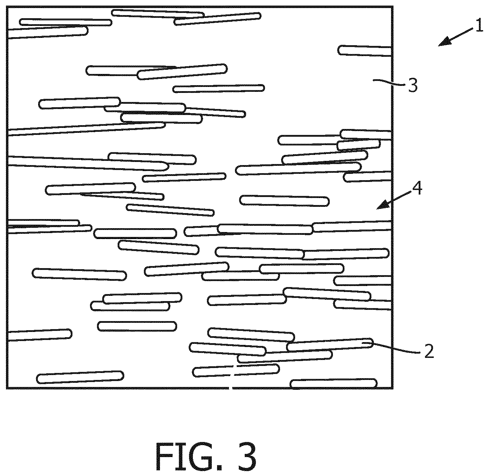

Fig. 3 schematically depicts a surface 1 covered with a compound material according to a third embodiment of the invention. The fibers or wires 4 of the fragmented superconducting material 2 shown in Fig. 3 are additionally essentially aligned in one direction. By using a production process that orients the fibers in a preferred direction the compound material can have engineered anisotropic properties. To achieve for example shielding against external sources like trains, elevators and cars in an embodiment of the invention the fibers or wires 4 of the fragmented superconducting material 2 are essentially aligned radially over a surface 1 of a main magnet or a shielding cylinder around the imaging volume of the magnetic resonance (MR) imaging system, wherein the longitudinal expansion of the fibers or wires 4 run in circumferential direction along the perimeter of the surface 1.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope. Further, for the sake of clearness, not all elements in the drawings may have been supplied with reference signs.

**REFERENCE SYMBOL LIST**

| | |
|---|---|
| surface of a magnetic shield | 1 |
| fragmented superconducting material | 2 |
| normal conducting metal or alloy | 3 |
| fibers or wires of the fragmented superconducting material | 4 |

## Claims

1. A compound material for a magnetic shield of a magnetic resonance (MR) imaging system the compound material comprising fragmented superconducting material (2), wherein the fragmented superconducting material (2) comprises fibers or wires (4), wherein the fibers or wires (4) of the fragmented superconducting material (2) are dispersed in a normal conducting metal or alloy (3).

2. The compound material according to claim 1, wherein the fragmented superconducting material (2) comprises fibers or wires (4) in a certain length, wherein the fibers or wires (4) are disposed in a high-density in the normal conducting metal or alloy (3), wherein the volumetric ratio of the fragmented superconducting material (2) in the compound material is between about 60% to about 95%.

3. The compound material according to claim 2, wherein the length of the fibers or wires (4) of the fragmented superconducting material (2) is from about 0.1 mm to about 8 cm.

4. The compound material according to claim 1, wherein the fragmented superconducting material (2) comprises fibers or wires (4) in a certain length, wherein the fibers or wires (4) are disposed in a low-density in the normal conducting metal or alloy (3), wherein the volumetric ratio of the fragmented superconducting material (2) in the compound material is between 5% to 40%.

5. The compound material according to claim 4, wherein the length of the fibers or wires (4) of the fragmented superconducting material (2) is about 8 cm and longer.

6. The compound material according to any preceding claim, wherein the fibers or wires (4) of the fragmented superconducting material (2) are essentially aligned in one direction.

7. The compound material according to claim 6, wherein the fibers or wires (4) of the fragmented superconducting material (2) are essentially aligned radially over a surface of a main magnet of the magnetic resonance (MR) imaging system.

8. A magnetic shield for a magnetic resonance (MR) imaging system, wherein at least one surface of the magnetic shield (1) is covered with the compound material according to any of claims 1 to 7.

9. A magnetic resonance (MR) imaging system comprising a magnetic shield according to claim 8.

10. A magnetic resonance (MR) imaging system according to claim 9, wherein the magnetic shield is disposed around a coldhead of a magnet of the MR imaging system.

11. A method for producing a compound material for a magnetic shield of a magnetic resonance (MR) imaging system, comprising the steps of
- providing a normal conducting metal or alloy (3),
- providing fibers or wires (4) of a fragmented superconducting material (2),
- forming an emulsion of the normal conducting metal or alloy (3) with the fibers or wires (4) of the fragmented superconducting material (2).

12. The method according to claim 11, wherein the step of forming an emulsion of the normal conducting metal or alloy (3) with fibers or wires (4) of the fragmented superconducting material (2), comprises the step of commonly aligning the fibers or wires (4) essentially in one direction.
